# EUROPEAN PATENT SPECIFICATION

(11) **EP 3 253 184 B1**
(45) Date of publication and mention of the grant of the patent: **11.08.2021**
(21) Application number: 17172971.8
(22) Date of filing: 25.05.2017
(51) Int. Cl.: H05H 1/36, H05H 1/46, H01J 37/32, H03H 7/40

(54) **MULTI FREQUENCY PLASMA GENERATING DEVICE AND ASSOCIATED METHOD**
MEHRFREQUENZVORRICHTUNG ZUR PLASMAERZEUGUNG UND VERFAHREN DAZU
DISPOSITIF DE PRODUCTION DE PLASMA MULTIFRÉQUENCE ET PROCÉDÉ ASSOCIÉ

(30) Priority: 03.06.2016 EP 16001275
(43) Date of publication of application: 06.12.2017
(73) Proprietor: Leibniz-Institut für Plasmaforschung und Technologie e.V., 17489 Greifswald (DE)
(72) Inventor: Klaus-Dieter Weltmann, 18609 Ostseebad Blnz (DE); Stephan Reuter, Princeton 08542 New Jersey (US); Robert Bansemer, 18445 Kramerhof (DE)
(74) Representative: Schulz Junghans Patentanwälte PartGmbB

(56) References cited:
- WO-A1-96/25757
- US-A1- 2012 168 081
- US-A1- 2013 015 766
- US-B1- 6 570 333

## Description

The invention relates to a device for generating a plasma, particularly an atmospheric pressure plasma (in the following termed atmospheric plasma), particularly an atmospheric plasma jet.

A plasma is an electrically quasi-neutral, ionized state of a gas, which is composed of ions, free electrons, and neutral species. In contrast to a normal gas, some or all of the outer electrons of the gas atoms have been separated from the respective atom to form ions and free electrons. For instance, such a plasma can be generated by coupling a radio frequency energy capacitively into a gas flow. With electrons separated from atoms of the gas, the plasma will readily interact with electric and magnetic fields. Due to the reactivity of the reactive species generated by the charged species in the plasma one of the important applications - among others - is the treatment of sensitive surfaces, particularly for medical purposes.

In this field, atmospheric plasma jets having low temperatures are of particular importance.

Particular plasma sources that are well known in the prior art and capable of producing cold atmospheric plasma jets are the so-called kINPen that is configured to generate a filamentary discharge in a dielectric tubing with a grounded outer ring electrode at an operating frequency of 1 MHz as well as the so-called µ-APPJ device (Schulz-von der Gathen et al; 2008 J. Phys. D: Appl. Phys. 41 194004) that is configured to generate a capacitively coupled RF-discharge with symmetric, co-planar, stainless steel electrodes enclosed by two quartz panes and a discharge volume of 1mm x 1mm x 30mm at a single operating frequency of 13.56 MHz of the voltage applied to the electrodes (200V).

US 2012/0168081 A1 discloses a plasma generating device with an impedance matching unit configured to match the plasma impedance. This unit comprises an adjustable capacitor having a plurality of capacitors and a plurality of switches corresponding to the plurality of capacitors.

Based on the above, the problem underlying the present invention is to provide a device for generating a plasma, particularly an atmospheric plasma, that is more versatile concerning generation of the plasma.

This problem is solved by a device having the features of claim 1 and a method having the features of claim 13.

Preferred embodiments of the device and the method of the present invention are stated in the corresponding dependent claims and are described below.

Accordingly, the present invention may be embodied as a device for generating an atmospheric plasma jet, which comprises a plasma source having a first electrode, and a volume arranged near the first electrode for receiving a gas; and at least one radiofrequency power supply in electrical contact with said first electrode for applying a radiofrequency voltage thereto. According to the invention, said at least one power supply is in electrical contact with the first electrode via a (particularly non-linear) electrical component, which electrical component provides an impedance for matching the impedance of the plasma source to the impedance of the power supply, wherein said electrical component is arranged in an enclosure that is particularly maintained at a separate potential, particularly at ground potential, which enclosure encloses said electrical component and is designed to perturb an electromagnetic field generated by said electrical component in a manner that said impedance of the electrical component changes with the frequency of said voltage such that the impedance of the plasma source is adapted to the impedance of the power supply (e.g. 50 Ohm) for a plurality of different operating frequencies of said voltage, enabling different operating frequencies to contribute to the ignition of and the power deployment into the plasma discharge.

Particularly, according to a preferred embodiment, said operating frequencies are related to each other by an integer factor.

Particularly, each of the said operating frequency fₕ can be an integer multiple of an operating frequency fₙ, i.e. fₕ=n*fₙ.

Particularly, in case there are two operating frequencies, i.e., a higher operating frequency and a lower operating frequency, the higher operating frequency can be an integer multiple of the lower frequency.

For this, for coupling energy into the plasma, an electrical signal may be used, that comprises a monotonous sinus signal or a superposition of several sinus signals of different frequency. The usable frequency values are particularly defined by the design of the coil-based resonator according to the present invention. It is possible to deviate from each nominal frequency value of the operating frequency by accepting an increase in the input reflection associated to the respective frequency component. Thus, utilizing a suitable dimensioning of the resonator and particularly a small displacement of the respective operating frequency away from the respective optimum (regarding the input reflection), two operating frequencies can be selected wherein one of these frequencies is an integer multiple of the other one.

Particularly, using operating frequencies that are related to each other in this way is beneficial, since the total signal comprises the same period than the slower partial signal which allows to establish a phase reference between these signals in a simple manner.

Thus, applications of the present invention, particularly in the field of diagnostics show an improved accessibility (particularly phase resolved emission spectroscopy). Furthermore, the characteristics of the plasma itself may be controlled more accurately.

In all embodiments, said volume can be formed by a channel. In the following the notion channel is often used. However, in all embodiments the channel be a general volume, including, particularly, an elongated channel or gap.

Further, below, specific dimensions and parameters are stated in certain embodiments. It is to be noted however that the invention is not restricted to these dimensions/parameters.

In the framework of the present invention, adapting the impedance of the plasma source to the impedance of the power supply particularly means that the adaption of the impedances allows to transfer sufficient power from the power supply to the plasma source for all operating frequencies such that a plasma discharge can be ignited for each of said operating frequencies.

Particularly, it was found that the impedances of the plasma source and the energy source need not match perfectly, but allow for a dampening of the known input reflection coefficient S₁₁ of more than 6dB (the input reflection S₁₁ is zero when no energy is reflected and assumes the value 1 in case all energy is reflected corresponding to a total mismatch of the impedances). This dampening of 6dB corresponds to a transfer of at least 75% of the power generated by the power supply to the plasma source.

According to a preferred embodiment of the present invention said electrical component is a coil.

According to an embodiment of the present invention, the coil extends in an axial direction and comprises a plurality of turns wound around said axial direction. Further, according to an embodiment of the present invention, said coil is an air-core coil. Furthermore, this coil can comprise a helically wound wire, which is wound around said axial direction. Particularly, said wire can be a copper wire.

Further, according to a preferred embodiment of the present invention, the device comprises a second electrode being arranged adjacent the first electrode, preferably opposite said first electrode, wherein particularly said channel (or volume) is arranged between the first and the second electrode. The electrodes can also be arranged with respect to each other in any other fashion that allows coupling of the radiofrequency energy into the gas supplied to the channel (or volume) so as to ignite the plasma. Particularly, the second electrode can also be arranged perpendicular or otherwise near the first electrode. Furthermore, a dielectric can be arranged between the plasma (i.e. the channel or volume) and the first and/or second electrode.

According to an embodiment of the present invention, said coil comprises a length in said axial direction in the range from 10mm to 30mm, wherein particularly said length is 20 mm.

Further, according to an embodiment of the present invention, said coil comprises a plurality of turns in the range from 10 turns to 35 turns, wherein the coil particularly comprises 16 turns.

Further, according to an embodiment of the present invention, said coil comprises a diameter, namely in a plane running perpendicular to the axial direction of the coil, in the range from 30mm to 70 mm, wherein particularly said diameter is 50 mm.

Further, according to an embodiment of the present invention, said channel is an elongated gap extending along a longitudinal axis between the first and the second electrode which extend parallel with respect to each other. Particularly, said channel comprises an opening at a first end of the channel that is in flow connection to the ambient atmosphere such that the channel can be maintained/operated near or at normal pressure (e.g. about 1.01325 bar) in particular. Particularly, the channel comprises a second end opposite the first end which is in flow connection to a gas supply (see below).

Further, according to an embodiment of the present invention, said electrodes are preferably formed symmetrically with respect to said longitudinal axis (which forms a central axis of the channel) and are preferably arranged in co-planar fashion.

Further, according to an embodiment of the present invention, the channel comprises a height in the range from 0.5mm to 1.5mm, particularly 1mm, which height corresponds to the distance between the electrodes perpendicular to the longitudinal axis.

Further according to an embodiment of the present invention, the channel comprises a width in the range from 0.5mm to 1.5mm, particularly 1mm, perpendicular to the longitudinal axis as well as perpendicular to the direction of said height (or distance between said electrodes).

Further according to an embodiment of the present invention, the channel and/or electrodes may comprise a length in the direction of the longitudinal axis in the range from 30mm to 60mm.

Further in a second end section of the channel at the second end of the channel into which the gas is preferably fed, the gap is preferably wider (e.g. in the height direction) so as to form a zone in the channel where no plasma discharge is ignited and from which the gas is distributed into the actual discharge volume having a constant height (i.e. distance between said electrodes) in said height direction, which can take the above-stated values in particular.

Further, the electrodes may be arranged on top of one another in the vertical direction and may be covered from both sides with transparent panes which may serve as an insulation of the electrodes and allow observing of the plasma discharge Particularly, the electrodes and adjacent components can be configured as described by Schulz-von der Gathen and co-workers (e.g. 2008 J. Phys. D: Appl. Phys. 41 194004).

Further, according to a preferred embodiment of the present invention, said enclosure is a cuboid housing.

According an embodiment of the present invention, said cuboid housing comprises an inner length in said axial direction of the coil in the range from 60 mm to 120mm, particularly 90 mm. Further, according to an embodiment of the present invention, the housing comprises an inner width (i.e. in a direction perpendicular to said inner length) in the range from 30mm to 90mm, particularly 60 mm. Further, in an embodiment of the present invention, said cuboid housing comprises an inner height (perpendicular to said inner width and length) in the range from 30mm to 90mm, particularly 60 mm.

Further, according to an embodiment of the present invention, the enclosure (e.g. cuboid housing) is made out of a metal, particularly steel, particularly stainless steel.

Further, according to an embodiment of the present invention, said electrodes protrude from a face side of said enclosure (e.g. cuboid housing), particularly in said axial direction of the coil, which axial direction preferably extends in the horizontal direction. Particularly said face side extends perpendicular to said axial direction, so that in the case of an enclosure in the form of said cuboid housing said face side comprises said inner height and width.

Furthermore, according to an embodiment of the present invention, the device comprises a gas supply in flow connection with said channel (particularly with said second end of the channel) for supplying said gas to said channel.

Further, according to an embodiment of the present invention, said gas is selected from the group consisting of air, noble gasses, oxygen, nitrogen, molecular gasses, and mixtures thereof.

Particularly, according to an embodiment of the present invention, said gas comprises a noble gas and oxygen (O₂), wherein preferably said gas comprises one of the following:
- less than 10Vol.-% oxygen,
- less than 5 Vol.-% oxygen,
- less than 4 Vol.-% oxygen,
- less than 3 Vol.-% oxygen,
- less than 2 Vol.-% oxygen,
- less than 1 Vol.-% oxygen,
- less than 0.6 Vol.-% oxygen,
- 0.5 Vol.-% oxygen,
- less than 0.5 Vol.-% oxygen,
- less than 0.4 Vol.-% oxygen,
- less than 0.3, Vol.-% oxygen,
- less than 0.1 Vol.-% oxygen,
- less than 0.05 Vol.-% oxygen,
wherein for each of these oxygen amounts stated above the rest of the gas is preferably said noble gas, wherein particularly said noble gas is helium or argon.

Further, according to an embodiment of the present invention, said gas comprises a noble gas and nitrogen (N₂), wherein preferably said gas comprises one of the following:
- less than 10Vol.-% nitrogen,
- less than 5 Vol.-% nitrogen,
- less than 4 Vol.-% nitrogen,
- less than 3 Vol.-% nitrogen,
- less than 2 Vol.-% nitrogen,
- less than 1 Vol.-% nitrogen,
- less than 0.6 Vol.-% nitrogen,
- 0.5 Vol.-% nitrogen,
- less than 0.5 Vol.-% nitrogen,
- less than 0.4 Vol.-% nitrogen,
- less than 0.3, Vol.-% nitrogen,
- less than 0.1 Vol.-% nitrogen,
- less than 0.05 Vol.-% nitrogen,
wherein for each of these nitrogen amounts stated above the rest of the gas is preferably said noble gas, wherein particularly said noble gas is helium or argon.

Further, according to an embodiment of the present invention, said gas comprises a noble gas, nitrogen (N₂) and oxygen (O₂), wherein preferably said gas comprises one of the following:
- less than 10Vol.-% nitrogen and oxygen,
- less than 5 Vol.-% nitrogen and oxygen,
- less than 4 Vol.-% nitrogen and oxygen,
- less than 3 Vol.-% nitrogen and oxygen,
- less than 2 Vol.-% nitrogen and oxygen,
- less than 1 Vol.-% nitrogen and oxygen,
- less than 0.6 Vol.-% nitrogen and oxygen,
- 0.5 Vol.-% nitrogen and oxygen,
- less than 0.5 Vol.-% nitrogen and oxygen,
- less than 0.4 Vol.-% nitrogen and oxygen,
- less than 0.3, Vol.-% nitrogen and oxygen,
- less than 0.1 Vol.-% nitrogen and oxygen,
- less than 0.05 Vol.-% nitrogen and oxygen,
wherein for each of these combined nitrogen and oxygen amounts the rest of the gas is preferably said noble gas. Further, in each of these combined nitrogen and oxygen amounts nitrogen and oxygen are preferably used in equal parts. Furthermore, said noble gas is preferably helium or argon.

Further, according to an embodiment of the present invention, the gas supply is configured for supplying gas into said channel at a flow rate in the range from 0.1 slm to 5 slm, preferably at a flow rate of 1 slm, wherein slm is an abbreviation for standard litre per minute corrected to standardized conditions of temperature and pressure, wherein 1 slm is equal to 1.68875 Pa*m³/s.

Furthermore, according to an embodiment of the present invention, the power supply is configured to generate a radio frequency voltage to be applied to the first electrode, which voltage is a superposition of a plurality of individual radio frequency voltages, wherein each of said superimposed voltages has one of said operating frequencies, and wherein particularly the power supply is also configured to allow for adjusting the amplitudes of the individual voltages to be superimposed.

As already indicated above, the operating frequencies can be related by an integer factor. Particularly, also here, a higher operating frequency (of two operating frequencies) can be an integer multiple of the lower one.

According to a further aspect, the present invention may be embodied as a method for generating (or operating) an atmospheric plasma jet, wherein
- the impedance of a plasma source having
   ∘ a first electrode,
   ∘ optionally a second electrode being arranged near or opposite the first electrode and particularly maintained at ground potential,
   ∘ an (e.g. non-linear) electrical component (particularly a coil, see above) via which at least one radiofrequency power source is electrically connected to the first electrode, and
   ∘ a volume (or channel) arranged near the first electrode (and/or between the first and the second electrode) for receiving a gas,
   is matched to the impedance of said at least one power supply for a plurality of operating frequencies of a voltage generated by the power supply that is to be applied to the first electrode, by enclosing said electrical component connecting the at least one power supply to the first electrode with an enclosure so as to perturb an electromagnetic field generated by said electrical component in a manner that said impedance of the electrical component changes with the frequency of said voltage such that the impedance of the plasma source is adapted to the impedance of the at least one power supply for said plurality of different operating frequencies of said voltage (see also above),
the method further comprises the steps of:
- supplying a gas to said volume (or channel) that particularly extends between said electrodes,
- igniting a plasma discharge in said volume (or channel) by applying a radio frequency voltage generated by the at least one power supply to the first electrode which comprises one of said operating frequencies, or which is a superposition of individual voltages, wherein each of said individual voltages comprises one of said operating frequencies.

Particularly, said enclosure may be maintained at a separate potential, particularly at ground potential (see also above).

According to a preferred embodiment of the method according to the invention, at least one property of the plasma (e.g. an antibacterial efficacy) is adjusted by an appropriate selection of said operating frequency of said voltage, or by an appropriate selection of said operating frequencies of said individual superimposed voltages as well as by selection of the amplitudes of said individual voltages.

Here, adjusting also the amplitudes of the individual voltage allows a variable mixing of the frequency where single frequencies can be weighted as desired.

Further, according to a preferred embodiment of the method according to the invention, the substance amount fraction of at least one reactive species generated in the plasma is adjusted by an appropriate selection of said operating frequency of said voltage, or by an appropriate selection of said operating frequencies of said individual voltages (that are superimposed to form said voltage to be applied to the first electrode) as well as by selection of the amplitudes of said individual voltages. Particularly, said reactive species can be ions, electrons, excited species, atoms, radicals, stable chemical species. Furthermore, reactive components of the plasma may also comprise electromagnetic radiation and fields.

Further, according to an embodiment of the method according to the invention, the gas comprises one of:
- a noble gas and oxygen, so as to generate at least one reactive oxygen species, particularly atomic oxygen derived species, particularly O and/or O₃, wherein preferably said noble gas is helium or argon,
- a noble gas and nitrogen, so as to generate at least one reactive nitrogen species, particularly NO₂, wherein preferably said noble gas is helium or argon,
- a noble gas, oxygen and nitrogen, so as to generate reactive oxygen and nitrogen species, particularly atomic oxygen derived species, particularly O and/or O₃, and NO₂, wherein preferably said noble gas is helium or argon.

Preferably, these mixtures of a noble gas (e.g. helium or argon) and nitrogen and/or oxygen, may have the compositions stated above.

Further, according to a preferred embodiment of the method according to the invention, the substance amount fraction of said plasma-generated reactive (oxygen and/or nitrogen) species is adjusted
- by selection of the operating frequency of said voltage from said plurality of different operating frequencies, or
- by selection of the operating frequencies (fₒ) of said individual voltages from said plurality of different operating frequencies (fₒ) as well as by selection of the amplitudes of the individual voltages.

Preferably, according to an example of the present invention, said operating frequencies are selected from 16.8 MHz, 62.1 MHz and 105.7 MHz. Small deviations from these values are tolerable, e.g. in the range of +/- 30 kHz.

Furthermore, a device according to the invention as described herein may be used in the method according to the invention. Therefore, the features and embodiments described in relation to the device according to the invention may also be applied in the method according to the invention.

Further, concerning the features and embodiments described herein, the person skilled in the art readily understands that these individual features and embodiments can be combined in an arbitrary fashion as long as they are not mutually exclusive in a technical sense and as long as they remain within the extent of the present invention, said extent determined by the claims.

In the following embodiments, further features and advantages of the invention shall be described with reference to the Figures, wherein
- Fig. 1: shows a perspective view of an embodiment of the device according to the invention;
- Fig. 2: shows a schematical cross sectional view of the device according to the invention;
- Fig. 3: shows the input reflection S₁₁ according to a numerical simulation of the plasma source according to the invention;
- Fig. 4: shows measured input reflections S₁₁ for the individual operating frequencies;
- Fig. 5: shows measured substance amount fraction ratios of plasma-generated reactive oxygen and nitrogen species;
- Fig. 6A, 6B: shows the space-resolved plasma dynamics in single-frequency mode;
- Fig. 7A, 7B: shows the space-resolved plasma dynamics in multi-frequency mode;
- Fig. 8: shows the influence of the generated plasma on an inhibiting areola (E. coli); and
- Fig. 9: shows the influence of the plasma on cell activity.

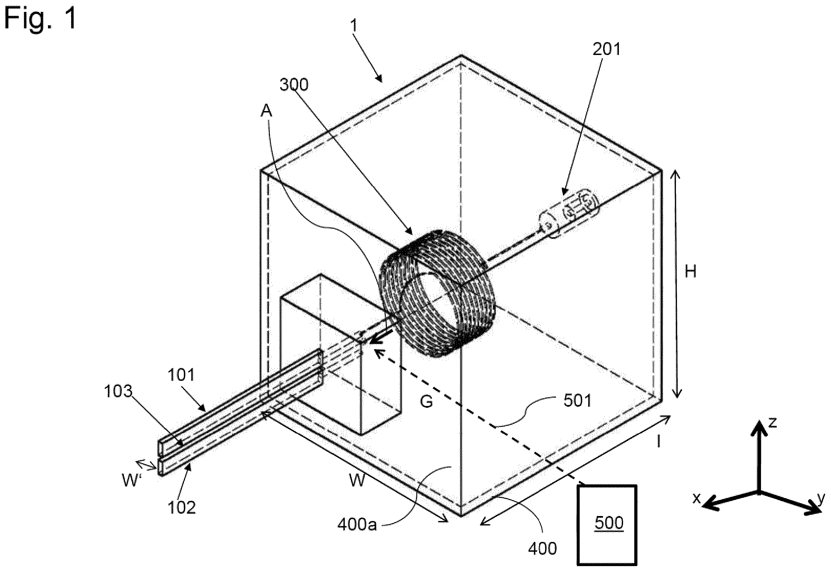

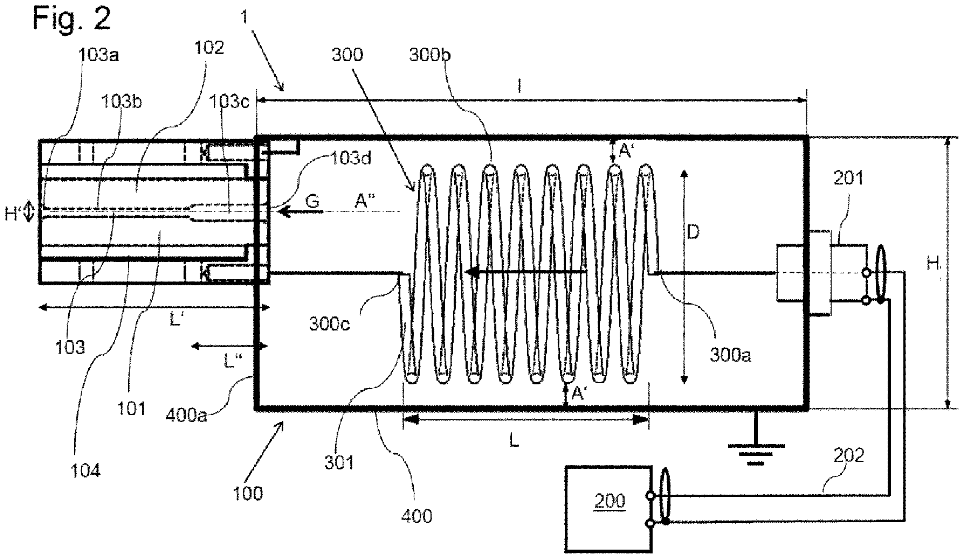

Fig. 1 shows in conjunction with Fig. 2 a device 1 according to the invention for generating an atmospheric plasma jet. For this, the device 1 comprises a plasma source 100 having a first electrode 101, a second electrode 102 being arranged opposite the first electrode 101, and a channel 103 arranged between first and the second electrode 101, 102 for receiving a gas G.

The device 1 further comprises a radiofrequency power supply 200 in electrical contact with said first electrode 101 for applying a radiofrequency voltage V thereto, wherein the second electrode 102 is maintained at ground potential.

To achieve an adequate impedance matching between the plasma source 100 and the power supply 200 that comprise an impedance of e.g. 50 Ohm using each of the desired operating frequencies fₒ, a coil-based resonator 300, 400 is used as the main matching element.

The resonator comprises an enclosure 400 which encloses a coil 300 via which the first electrode 101 is connected to the power supply 200, i.e., the coil 300 comprises a first end 300a being electrically connected to the power supply 200 and a second end 300c being electrically connected to the first electrode 101, wherein said two ends 300a, 300c are connected to each other by a helically wound section 300b of the coil 300, wherein the wire or turns of the coil 300 are wound around an axial direction A along which the coil 300 extends. Particularly, the connection from the coil 300 to the power supply 200 can be made via a coaxial connector 201 arranged on the enclosure 400 and a coaxial line 202. The coil 300 can be formed by a helically wound copper wire that may be mounted on a thin plastic tube for holding the wire.

Further, said electrodes 101, 102 extend along a longitudinal axis A" and protrude from a face side 400a of said enclosure 400 in the direction of said axis A". Preferably said longitudinal axis A" runs parallel to the axial direction (i.e. central coil axis) A. Said face side 400a may face away from a side of the enclosure 400 on which said connector 201 is mounted. The two electrodes 101, 102 are formed symmetrically with respect to said longitudinal axis A" and are preferably arranged with respect to each other in co-planar fashion so that a volume, here as an example in the form of an elongated channel or gap 103 is formed between the two electrodes 101, 102 that extends along said longitudinal axis A". The channel 103 comprises an opening at a first end 103a of the channel 103 that is in flow connection to the ambient atmosphere such that the channel 103 can be maintained/operated near or at normal pressure (e.g. about 1.013 25 bar). The channel 103 further comprises a second end 103d opposite the first end 103a which is in flow connection to a gas supply 500 that is configured to supply a gas G to the channel 103 that may comprise a flow rate and composition as described herein.

The channel 103 particularly comprises a height H' of 1mm, which height corresponds to the distance between the electrodes 101, 102 perpendicular to the longitudinal axis A". Further, the channel 103 particularly comprises a width W of 1mm perpendicular to the longitudinal axis A" as well as perpendicular to the direction of said height H' (or distance between said electrodes 101, 102).

Furthermore, the channel 103 and/or electrodes 101,102 particularly comprise a length L' in the direction of the longitudinal axis A" of 30 mm.

Further, in a second end section 103c of the channel 103 at the second end 103d of the channel 103 into which said gas G is fed, the gap 103 is preferably wider (e.g. in the height direction H') so as to form a zone 103c in the channel 103 where no plasma discharge is ignited and from which the gas G is distributed into the actual discharge volume/section 103b of the channel 103 having said constant height H'. The length L" of this zone 103c is 10 mm in particular.

Laterally, the channel may be covered by two (e.g. transparent) side walls or panes 104.

The enclosure 400 is particularly formed as a cuboid housing made of e.g. stainless steel and is located in proximity to the coil 300. This leads to a significant disturbance of the electromagnetic fields which spread outside the coil 300. Thus, the well-known coil behavior describable as an inductance in series with a resistance is no longer applicable to the device 1. Instead, the resistor's impedance changes its characteristics depending on the frequency. Knowing the impedance of the plasma source 100 which should be matched, housing size I, W, H, coil length L, number of turns 301 and coil diameter D can be determined to fit to the desired frequencies fₒ as the solution of an optimization problem using a 3D numeric simulation (see also examples below).

Particularly, as an example, the housing 400 comprises an inner length of 90mm in the axial direction A along which the coil 300 extends that is arranged in the enclosure 400 in a centered fashion, wherein particularly the minimal distance A' between the coil 300 and the inside of the enclosure 400 is 5mm in the radial direction of the coil 300.

Further, the enclosure 400 particularly comprises an inner height H in a direction perpendicular to the axial direction (e.g. in the vertical direction) A of 60mm as well as an inner width W of 60mm in a direction running perpendicular to the axial direction A and said height direction.

In conjunction with a coil (e.g. copper wire) 300 having a length L of 20 mm in the axial direction A using 16 helical turns (for simplicity less turns are shown in Fig. 2) and a diameter D of 50 mm in the plane extending perpendicular to the axial direction A, this particularly leads to three usable operating frequencies fₒ. Here, for instance, a plasma can be ignited in a 1 slm helium gas flow between the first and the second electrodes 101, 102 attached to the enclosure 400 using the operating frequencies fₒ of 16.8 MHz, 62.1 MHz and 105.7 MHz.

Furthermore, the power supply 200 is configured to mix signals having different operating frequencies fₒ and to allow for adjusting the amplitudes of the individual signals for precisely tuning the characteristics and properties of the generated plasma (see also below).

### Example 1

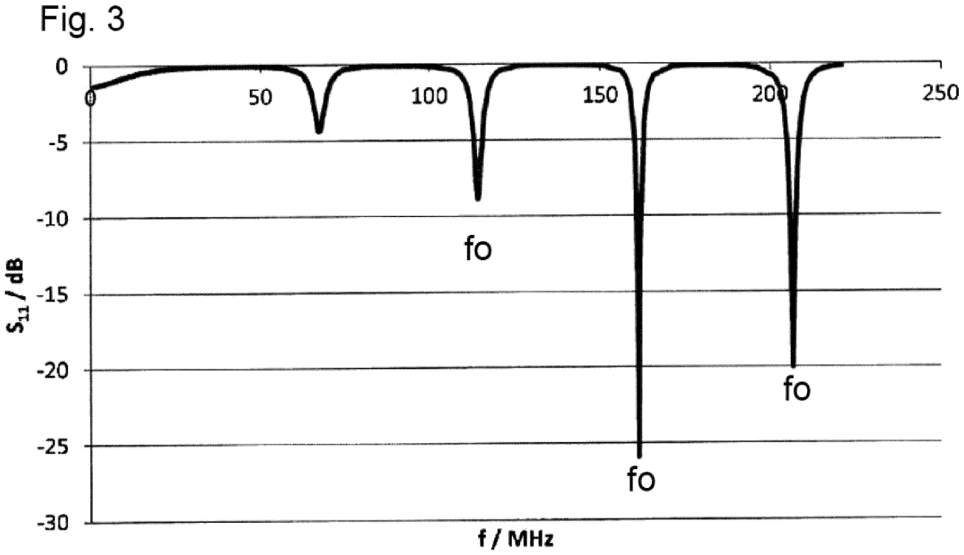

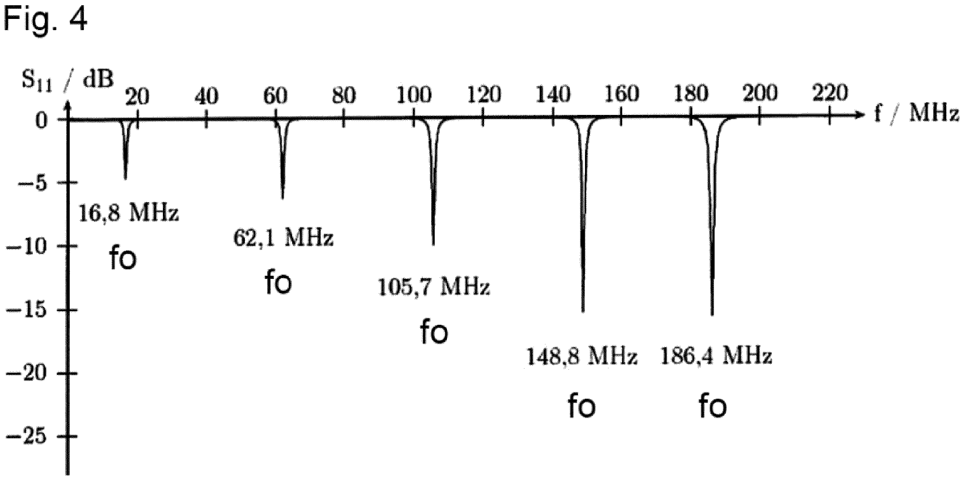

The impedance of the above described plasma source 100 of device 1 was matched according to the invention to the usual source impedance of 50 Ohm of the power supply 200. Impedance matching was considered to be sufficient when the magnitude of the input reflection S₁₁ was dampened by more than 6dB which corresponds to feeding more than 75% of the provided power into the plasma source 100. The plasma source 100 was numerically simulated (Comsol Multiphysics). The result is shown in Fig. 3 which shows the calculated S₁₁ as a function of the frequency f yielding the operating frequencies fₒ for which the impedance matching via coil 300 and enclosure 400 is successful according to the above-stated criterion. In addition, measuring the input reflection S₁₁ using a network analyzer confirms the simulation nicely and yields operating frequencies fₒ of 16.8 MHz, 62.1 MHz and 105.7 MHz which are shown in Fig. 4.

For instance, the two lowest operating frequencies fₒ can be used individually or together for igniting a stable plasma discharge of plasma source 100. Further, for instance, the operating point at fₒ equal to 105.7MHz can be used in a superposition signal.

Using these operating frequencies fₒ, a plasma can be ignited in helium or argon (e.g. 1slm), particularly with nitrogen and/or oxygen as an admixture (see also below). For instance, a signal portion having 105.7 MHz can be used together with one of the lower operating frequencies fₒ.

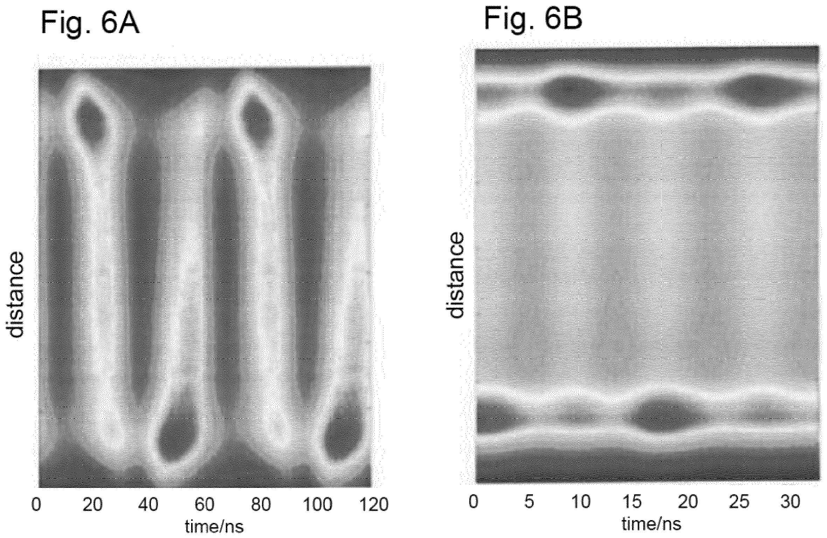

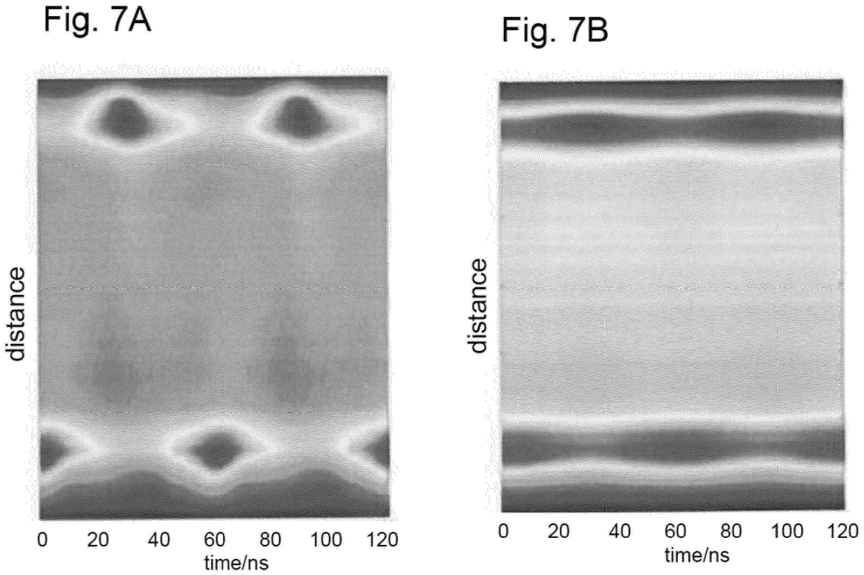

Figs. 6A and 7A show the plasma dynamics using a single operating frequency fₒ of 16.4MHz (Fig. 6A) and 62.1MHz (Fig. 6B), wherein these Figures show the optical emission in the channel 103 in a space-resolved fashion (ordinate) over two periods of the excitation frequency fₒ.

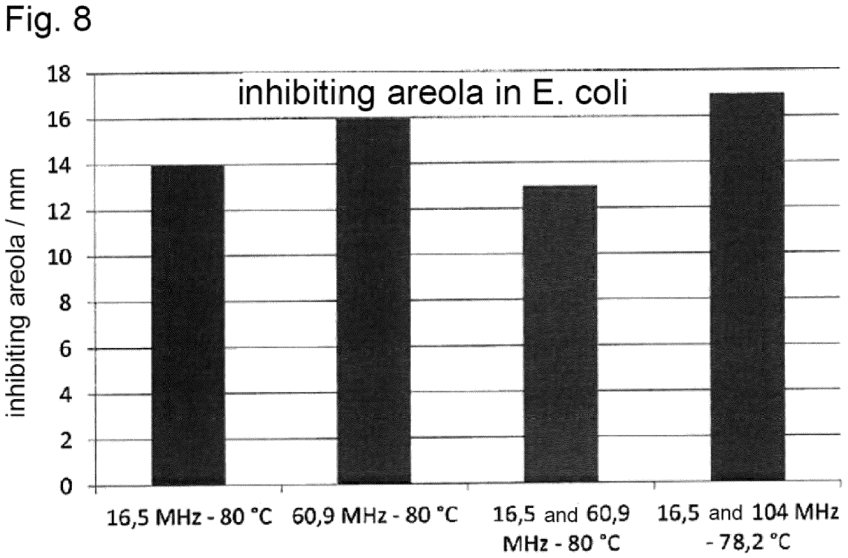

Furthermore, Figs. 7A and 7B show the plasma dynamics at 16.4MHz superimposed with a signal of 62.1MHz, wherein Fig. 8A shows the plasma dynamics in the low frequency dominated two frequency mode, while Fig. 8B shows the plasma dynamics in the high frequency dominated two frequency mode.

### Example 2

Operating the plasma in a multi-frequency fashion allows adjusting the plasma chemistry using an independent parameter. Different excitation or operating frequencies fₒ excite different components of the plasma. Thus, an appropriate selection of the parameters, e.g. operating frequencies fₒ, allows to adjust the plasma properties such that the composition of the generated reactive species can be influenced specifically without changing the feed gas G. Particularly, the method according to the invention allows to adjust the composition of the generated reactive species using multi-frequency excitation without changing the feed gas.

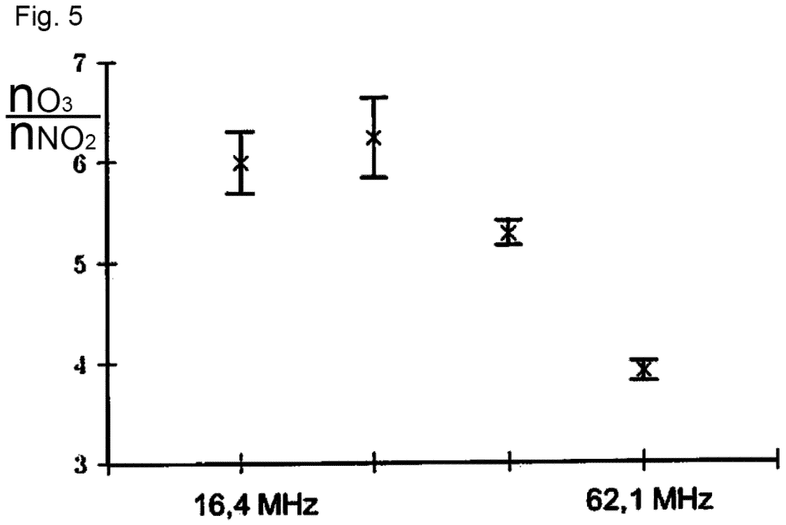

In this regard, Fig. 5 shows the ratio of the substance amount fractions, i.e., n_{O3}/n_{NO2} of the plasma-generated reactive species O₃ and NO₂ at the two lowest operating frequencies fₒ, i.e. 16.4 MHz and 62.1 MHz. In between, the generated substance amount fraction ratio is shown for a superimposed feed of these two operating frequencies fₒ for different amplitude ratios. As can be seen from Fig. 5, the substance amount fractions of the shown reactive species can be adjusted by selecting the frequencies fₒ and particularly amplitude ratios appropriately.

### Example 3

Further, as an example for the suitability of the multi-frequency operation of the plasma source 100 according to the invention regarding wound healing, Escherichia coli (E. coli) samples were treated with the plasma source 100 which was run with a gas G comprised of helium and 0.5 Vol.-% oxygen as an admixture. Four different operating points allow a comparison between the known single frequency operation and the superimposition of two operating frequencies fₒ. The used input power of the four operating points was adjusted using a fiber-optic temperature probe used to ensure that the gas temperature in the center of the channel 103 was at a constant 80°C.

The results are depicted in Fig. 8 which shows the inhibiting areola over the individual operating points. The results demonstrate that the operating frequency fₒ influences the development of the antibacterial efficacy and can be used to control said efficacy.

### Example 4

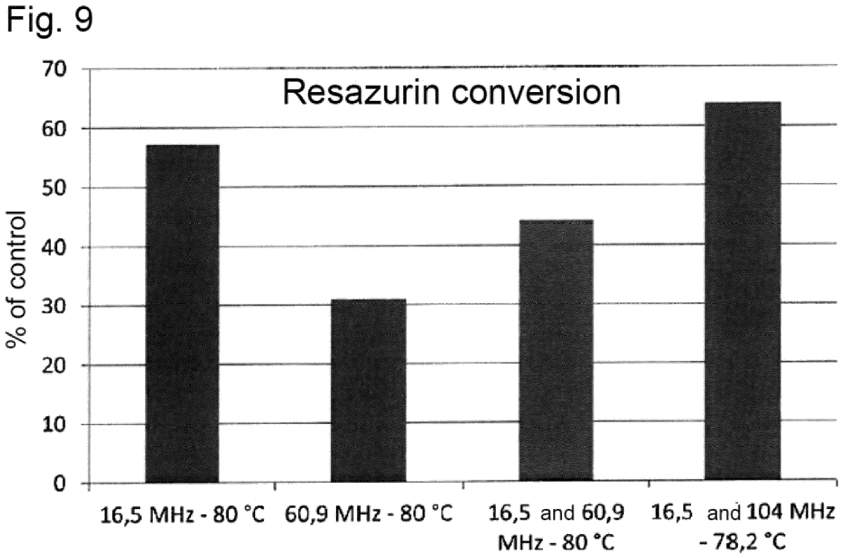

As a further example human skin tissue cells of a HaCaT cell line have been plasma-treated. The cell activity after the plasma treatment was measured with an AlamarBlue test. Here, helium was used as gas G with an admixture of equal parts of nitrogen and oxygen. The total portion of the admixed nitrogen and oxygen amounts to 0.5 Vol.-%. In the results shown in Fig. 9 the activity of the cells as a percentage of the control group is considered. As before, a constant power is defined by measuring the temperature in the center of the channel 103. It can be inferred from Fig. 9 that 16.5MHz influences the cell activity less than 60.9MHz. Mixing these two operating frequencies fₒ yields an influence on the cell activity whose intensity lies in between the two individual single frequency operating points. Mixing 16.4MHz and 104MHz yields a smaller weakening of the cell activity compared to the individual operating frequencies fₒ. This mixture shows the smallest influence in case of human cells but the largest effect against bacteria (indicated by the largest inhibiting areola). This demonstrates that the frequency mixing is a suitable entity for selectively controlling the activity of the plasma.

## Claims

1. A device (1) for generating a plasma, comprising:
- a plasma source (100) having an electrically conducting first electrode (101), and a volume (103) adjacent said first electrode (101) for receiving a gas (G),
- at least one radiofrequency power supply (200) in electrical contact with said first electrode (101) for applying a radiofrequency voltage (V) thereto;
wherein said at least one radiofrequency power supply (200) is in electrical contact with said first electrode (101) via an electrical component (300) of the plasma source (100), which electrical component (300) provides an impedance for matching the impedance of the plasma source (100) to the impedance of the at least one radiofrequency power supply (200), wherein said electrical component (300) is arranged in an enclosure (400), which enclosure (400) encloses said electrical component (300), **characterized in that** the enclosure (400) is designed to perturb an electromagnetic field generated by said component (300) in a manner that said impedance of the component (300) changes with the frequency of said radiofrequency voltage (V) such that the impedance of the plasma source (100) is adapted to the impedance of the at least one radiofrequency power supply (200) for a plurality of different operating frequencies (fₒ) of said radiofrequency voltage (V), wherein said plurality of different operating frequencies (fₒ) permit generating a plasma out of said gas (G) in said volume (103) when said radiofrequency voltage (V) having an operating frequency from the plurality of different operating frequencies (fₒ) is applied to the first electrode (101).

2. The device of claim 1, **characterized in that** the electrical component is a coil (300) extending in an axial direction (A) and comprising a plurality of turns (301) wound around said axial direction (A).

3. The device of claim 2, **characterized in that** said coil (300) is an air-core coil, and particularly comprises a helically wound wire (302).

4. The device of one of the preceding claims, **characterized in that** the device comprises a second electrode (102) being arranged opposite said first electrode, wherein particularly said volume (103) is formed by a channel (103) arranged between the first and the second electrode (101, 102).

5. The device of claim 2 or 3, **characterized in that** said coil (300) comprises a length (L) in said axial direction (A) in the range from 10mm to 30mm, wherein particularly said length (L) is 20 mm.

6. The device of one of the claims 2 to 5, **characterized in that** said coil (300) comprises a plurality of turns (301) in the range from 10 turns to 35 turns, wherein the coil (300) particularly comprises 16 turns (301).

7. The device according to one of the claims 2 to 5, **characterized in that** said coil (300) comprises a diameter (D) in the range from 30mm to 70 mm, wherein particularly said diameter (D) is 50 mm.

8. The device according to one of the preceding claims, **characterized in that** said volume (103) is an elongated gap extending along a longitudinal axis (A") between the first and the second electrode (101, 102), which electrodes (101, 102) extend parallel with respect to each other.

9. The device according to one of the preceding claims, **characterized in that** said enclosure (400) is a cuboid housing.

10. The device according to claim 2 and claim 8, **characterized in that** the housing comprises an inner length (I) in the axial direction (A) in the range from 60 mm to 120mm, particularly 90 mm, and an inner width (W) in the range from 30mm to 90mm, particularly 60 mm, and an inner height (H) in the range from 30mm to 90mm, particularly 60 mm.

11. The device according to one of the preceding claims, **characterized in that** the device (1) comprises a gas supply (500) in flow connection with said volume (103) for supplying said gas (G) to said volume (103).

12. The device according to one of the preceding claims, **characterized in that** the radiofrequency voltage (V) is a superposition of a plurality of individual radiofrequency voltages, wherein each of said individual radiofrequency voltages has one of said operating frequencies (fₒ).

13. Method for generating a plasma with a device (1) according to one of the preceding claims, the method comprising the steps of:
- supplying a gas (G) to the volume (103) of the plasma source (100),
- generating a plasma out of the gas (G) supplied to the volume (103) by applying a radiofrequency voltage (V) generated by the at least one radiofrequency power supply (200) of the device (1) to the first electrode (101) of the plasma source (100), which radiofrequency voltage (V) comprises one of the plurality of different operating frequencies (fₒ), or which radiofrequency voltage (V) is a superposition of individual radiofrequency voltages, wherein each of said individual radiofrequency voltages comprises one of said plurality of different operating frequencies (fₒ)
**characterized by** matching the impedance of said plasma source (100) to the impedance of said at least one radiofrequency power supply (200) for the plurality of the different operating frequencies (fₒ) of the radiofrequency voltage (V) that is applied to the first electrode (101), wherein the matching is achieved by enclosing said electrical component (300) in said enclosure (400) so as to perturb an electromagnetic field generated by said electrical component (300) in a manner that said impedance of the electrical component (300) changes with the frequency of said radiofrequency voltage (V) such that the impedance of the plasma source (100) is adapted to the impedance of the at least one power supply (200) for said plurality of different operating frequencies (f₀) of said radiofrequency voltage (V).

14. The method according to claim 13, **characterized in that** a property of the plasma is adjusted
- by selection of one operating frequency of said radiofrequency voltage (V) from said plurality of different operating frequencies (fₒ), or
- by selection of operating frequencies of said individual radiofrequency voltages from said plurality of different operating frequencies (fₒ) as well as by selection of the amplitudes of the individual radiofrequency voltages.

15. The method according to claim 13 or 14, **characterized in that** the substance amount fraction of at least one reactive species generated in said plasma is adjusted
- by selection of an operating frequency of said radiofrequency voltage from said plurality of different operating frequencies (fₒ), or
- by selection of operating frequencies of said individual radiofrequency voltages from said plurality of different operating frequencies (fₒ) as well as by selection of the amplitudes of the individual radiofrequency voltages.

## Patentansprüche

1. Ein Gerät (1) zur Erzeugung eines Plasmas, umfassend:
- eine Plasmaquelle (100) aufweisend eine elektrisch leitende erste Elektrode (101) und ein Volumen (103) benachbart zu besagter ersten Elektrode (101) zur Entgegennahme eines Gases (G),
- mindestens eine Hochfrequenz-Energieversorgung (200) in elektrischem Kontakt mit besagter ersten Elektrode (101) zum Anlegen einer Hochfrequenzspannung (V) an diese;
wobei besagte mindestens eine Hochfrequenz-Energieversorgung (200) in elektrischem Kontakt mit besagter ersten Elektrode (101) über eine elektrische Komponente (300) der Plasmaquelle (100) steht, deren elektrische Komponente (300) eine Impedanz zur Anpassungen der Impedanz der Plasmaquelle (100) an die Impedanz der mindestens einen Hochfrequenz-Energieversorgung (200) bereitstellt, wobei besagte elektrische Komponente (300) in einem Gehäuse (400) angeordnet ist, wobei das Gehäuse (400) besagte elektrische Komponente (300) umschließt, **dadurch gekennzeichnet, dass** das Gehäuse (400) so ausgestaltet ist, dass es ein elektromagnetisches Feld, das von besagter Komponente (300) erzeugt wird, in einer Weise beeinflusst, dass sich besagte Impedanz der Komponente (300) mit der Frequenz besagter Hochfrequenzspannung (V) ändert, so dass die Impedanz der Plasmaquelle (100) an die Impedanz der mindestens einen Hochfrequenz-Energieversorgung (200) für eine Vielzahl von unterschiedlichen Betriebsfrequenzen (f₀) besagter Hochfrequenzspannung (V) angepasst ist, wobei besagte Vielzahl von unterschiedlichen Betriebsfrequenzen (f₀) die Erzeugung eines Plasmas aus besagtem Gas (G) in besagtem Volumen (103) ermöglichen, wenn besagte Hochfrequenzspannung (V) mit einer Betriebsfrequenz aus der Vielzahl von unterschiedlichen Betriebsfrequenzen (f₀) an die erste Elektrode (101) angelegt ist.

2. Das Gerät nach Anspruch 1, **dadurch gekennzeichnet, dass** die elektrische Komponente eine Spule (300) ist, die sich in einer axialen Richtung (A) erstreckt und eine Vielzahl von Windungen (301) umfasst, die um besagte axiale Richtung (A) gewickelt sind.

3. Das Gerät nach Anspruch 2, **dadurch gekennzeichnet, dass** die Spule (300) eine Luftspule ist und insbesondere einen spiralförmig gewickelten Draht (302) umfasst.

4. Das Gerät nach einem der vorhergehenden Ansprüche, **dadurch gekennzeichnet, dass** das Gerät eine zweite Elektrode (102) umfasst, die gegenüber besagter erster Elektrode angeordnet ist, wobei insbesondere besagtes Volumen (103) durch einen Kanal (103) ausgebildet ist, der zwischen der ersten und der zweiten Elektrode (101, 102) angeordnet ist.

5. Das Gerät nach Anspruch 2 oder 3, **dadurch gekennzeichnet, dass** besagte Spule (300) eine Länge (L) in besagter axialer Richtung (A) im Bereich von 10 mm bis 30 mm aufweist, wobei insbesondere besagte Länge (L) 20 mm beträgt.

6. Das Gerät nach einem der Ansprüche 2 bis 5, **dadurch gekennzeichnet, dass** besagte Spule (300) eine Vielzahl von Windungen (301) im Bereich von 10 Windungen bis 35 Windungen umfasst, wobei die Spule (300) insbesondere 16 Windungen (301) umfasst.

7. Das Gerät gemäß einem der Ansprüche 2 bis 5, **dadurch gekennzeichnet, dass** besagte Spule (300) einen Durchmesser (D) im Bereich von 30 mm bis 70 mm umfasst, wobei insbesondere besagter Durchmesser (D) 50 mm beträgt.

8. Das Gerät gemäß einem der vorhergehenden Ansprüche, **dadurch gekennzeichnet, dass** besagtes Volumen (103) ein länglicher Spalt ist, der sich entlang einer Längsachse (A") zwischen der ersten und der zweiten Elektrode (101, 102) erstreckt, wobei die Elektroden (101, 102) parallel zueinander verlaufen.

9. Das Gerät nach einem der vorhergehenden Ansprüche, **dadurch gekennzeichnet, dass** besagtes Gehäuse (400) ein quaderförmiges Gehäuse ist.

10. Das Gerät gemäß Anspruch 2 und Anspruch 8, **dadurch gekennzeichnet, dass** das Gehäuse eine innere Länge (I) in axialer Richtung (A) im Bereich von 60 mm bis 120 mm, insbesondere 90 mm, und eine innere Breite (W) im Bereich von 30 mm bis 90 mm, insbesondere 60 mm, und eine innere Höhe (H) im Bereich von 30 mm bis 90 mm, insbesondere 60 mm, umfasst.

11. Das Gerät gemäß einem der vorhergehenden Ansprüche, **dadurch gekennzeichnet, dass** das Gerät (1) eine Gasversorgung (500) in Strömungsverbindung mit besagtem Volumen (103) zum Zuführen besagten Gases (G) zu besagtem Volumen (103) umfasst.

12. Das Gerät gemäß einem der vorhergehenden Ansprüche, **dadurch gekennzeichnet, dass** die Hochfrequenzspannung (V) eine Superposition einer Vielzahl von einzelnen Hochfrequenzspannungen ist, wobei jede von besagten einzelnen Hochfrequenzspannungen eine von besagten Betriebsfrequenzen (f₀) aufweist.

13. Verfahren zur Erzeugung eines Plasmas mit einem Gerät (1) gemäß einem der vorhergehenden Ansprüche, das Verfahren umfassend die Schritte:
- Zuführen eines Gases (G) zum Volumen (103) der Plasmaquelle (100),
- Erzeugen eines Plasmas aus dem dem Volumen (103) zugeführten Gas (G) durch Anlegen einer von der mindestens einen Hochfrequenz-Energieversorgung (200) des Geräts (1) erzeugten Hochfrequenzspannung (V) an die erste Elektrode (101) der Plasmaquelle (100), wobei die Hochfrequenzspannung (V) eine der Vielzahl von unterschiedlichen Betriebsfrequenzen (f₀) umfasst, oder wobei die Hochfrequenzspannung (V) eine Superposition von einzelnen Hochfrequenzspannungen ist, wobei jede von besagten einzelnen Hochfrequenzspannungen eine von besagter Vielzahl von unterschiedlichen Betriebsfrequenzen (f₀) umfasst, **gekennzeichnet durch** Anpassung der Impedanz der Plasmaquelle (100) an die Impedanz der besagten mindestens einen Hochfrequenz-Energieversorgung (200) für die Vielzahl der unterschiedlichen Betriebsfrequenzen (f₀) der Hochfrequenzspannung (V), die an die erste Elektrode (101) angelegt wird, wobei die Anpassung dadurch erreicht wird, dass besagte elektrische Komponente (300) in dem Gehäuse (400) eingeschlossen wird, um ein elektromagnetisches Feld, das von besagter elektrischer Komponente (300) erzeugt wird, in einer Weise zu beeinflussen, dass sich die Impedanz der elektrischen Komponente (300) mit der Frequenz der Hochfrequenzspannung (V) ändert, so dass die Impedanz der Plasmaquelle (100) an die Impedanz der mindestens einen Energieversorgung (200) für besagte Vielzahl von unterschiedlichen Betriebsfrequenzen (f₀) besagter Hochfrequenzspannung (V) angepasst ist.

14. Das Verfahren gemäß Anspruch 13, **dadurch gekennzeichnet, dass** eine Eigenschaft des Plasmas eingestellt wird
- durch Auswahl einer Betriebsfrequenz besagter Hochfrequenzspannung (V) aus besagter Vielzahl von unterschiedlichen Betriebsfrequenzen (f₀), oder
- durch Auswahl der Betriebsfrequenzen von besagten einzelnen Hochfrequenzspannungen aus besagter Vielzahl von unterschiedlichen Betriebsfrequenzen (f₀) sowie durch Auswahl der Amplituden der einzelnen Hochfrequenzspannungen.

15. Das Verfahren gemäß Anspruch 13 oder 14, **dadurch gekennzeichnet, dass** der Substanzmengenanteil von mindestens einer reaktiven Spezies, die in besagtem Plasma erzeugt wird, eingestellt wird
- durch Auswahl einer Betriebsfrequenz besagter Hochfrequenzspannung aus besagter Vielzahl von unterschiedlichen Betriebsfrequenzen (f₀), oder
- durch Auswahl der Betriebsfrequenzen besagter einzelner Hochfrequenzspannungen aus besagter Vielzahl von unterschiedlichen Betriebsfrequenzen (f₀) sowie durch Auswahl der Amplituden der einzelnen Hochfrequenzspannungen.

## Revendications

1. Dispositif (1) de génération d'un plasma, comprenant :
- une source de plasma (100) pourvue d'une première électrode (101) électriquement conductrice, et d'un volume (103) adjacent à ladite première électrode (101) pour la réception d'un gaz (G),
- au moins une source d'alimentation radiofréquence (200) en contact électrique avec ladite première électrode (101) pour appliquer une tension radiofréquence (V) à celle-ci ;
dans lequel ladite au moins une source d'alimentation radiofréquence (200) est en contact électrique avec ladite première électrode (101) par l'intermédiaire d'un composant électrique (300) de la source de plasma (100), ledit composant électrique (300) fournissant une impédance pour adapter l'impédance de la source de plasma (100) à l'impédance de ladite au moins une source d'alimentation radiofréquence (200), ledit composant électrique (300) étant disposé dans une enceinte (400), ladite enceinte (400) renfermant le composant électrique (300), **caractérisé en ce que** ladite enceinte (400) est conçue pour perturber un champ électromagnétique généré par le composant (300) de sorte que l'impédance du composant (300) varie avec la fréquence de ladite tension radiofréquence (V) de manière à adapter l'impédance de la source de plasma (100) à l'impédance de ladite au moins une source d'alimentation radiofréquence (200) pour une pluralité de différentes fréquences de service (f₀) de ladite tension radiofréquence (V), ladite pluralité de différentes fréquences de service (f₀) permettant la génération d'un plasma à partir du gaz (G) dans le volume (103) lorsque ladite tension radiofréquence (V) ayant une fréquence de service dans la pluralité de différentes fréquences de service (f₀) est appliquée à la première électrode (101).

2. Dispositif selon la revendication 1, **caractérisé en ce que** le composant électrique est une bobine (300) s'étendant dans une direction axiale (A), et présentant une pluralité de spires (301) enroulées autour de ladite direction axiale (A).

3. Dispositif selon la revendication 2, **caractérisé en ce que** la bobine (300) est une bobine à noyau d'air, et comprend notamment un fil métallique enroulé en hélice (302).

4. Dispositif selon l'une des revendications précédentes, **caractérisé en ce que** le dispositif comprend une deuxième électrode (102) étant disposée en opposition à ladite première électrode, dans lequel ledit volume (103) est notamment formé par un canal (103) disposé entre la première et la deuxième électrode (101, 102).

5. Dispositif selon la revendication 2 ou la revendication 3, **caractérisé en ce que** la bobine (300) présente une longueur (L) dans ladite direction axiale (A) comprise entre 10 mm et 30 mm, ladite longueur (L) étant notamment égale à 20 mm.

6. Dispositif selon l'une des revendications 2 à 5, **caractérisé en ce que** la bobine (300) comprend une pluralité de spires (301) comprise entre 10 spires et 35 spires, ladite bobine (300) comprenant notamment 16 spires (301).

7. Dispositif selon l'une des revendications 2 à 5, **caractérisé en ce que** ladite bobine (300) présente un diamètre (D) compris entre 30 mm et 70 mm, ledit diamètre (D) étant notamment égal à 50 mm.

8. Dispositif selon l'une des revendications précédentes, **caractérisé en ce que** ledit volume (103) est un interstice longiforme s'étendant le long d'un axe longitudinal (A") entre la première et la deuxième électrode (101, 102), lesdites électrodes (101, 102) s'étendant parallèlement entre elles.

9. Dispositif selon l'une des revendications précédentes, **caractérisé en ce que** ladite enceinte (400) est un boîtier cubique.

10. Dispositif selon la revendication 2 et la revendication 8, **caractérisé en ce que** le boîtier présente une longueur intérieure (I) dans la direction axiale (A) comprise entre 60 mm et 120 mm, notamment égale à 90 mm, et une largeur intérieure (W) comprise entre 30 mm et 90 mm, notamment égale à 60 mm, et une hauteur intérieure (H) comprise entre 30 mm et 90 mm, notamment égale à 60 mm.

11. Dispositif selon l'une des revendications précédentes, **caractérisé en ce que** le dispositif (1) comprend une alimentation en gaz (500) en communication fluidique avec ledit volume (103) pour fournir ledit gaz (G) au volume (103).

12. Dispositif selon l'une des revendications précédentes, **caractérisé en ce que** la tension radiofréquence (V) est une superposition d'une pluralité de tensions radiofréquences individuelles, dans lequel chacune desdites tensions radiofréquences individuelles a une des fréquences de service (f₀).

13. Procédé de génération d'un plasma avec un dispositif (1) selon l'une des revendications précédentes, ledit procédé comprenant les étapes suivantes :
- fourniture d'un gaz (G) au volume (103) de la source de plasma (100),
- génération d'un plasma à partir du gaz (G) fourni au volume (103) par application d'une tension radiofréquence (V) générée par ladite au moins une source d'alimentation radiofréquence (200) du dispositif (1) à la première électrode (101) de la source de plasma (100), ladite tension radiofréquence (V) présentant une fréquence de la pluralité de différentes fréquences de service (f₀), ou ladite tension radiofréquence (V) étant une superposition de tensions radiofréquences individuelles, dans lequel chacune desdites tensions radiofréquences individuelles présente une fréquence de la pluralité de différentes fréquences de service (f₀), **caractérisé par** l'adaptation de l'impédance de ladite source de plasma (100) à l'impédance de ladite au moins une source d'alimentation radiofréquence (200) pour la pluralité des différentes fréquences de service (f₀) de la tension radiofréquence (V) appliquée à la première électrode (101), ladite adaptation étant obtenue par disposition dudit composant électrique (300) dans ladite enceinte (400) de manière à perturber un champ électromagnétique généré par ledit composant électrique (300) de sorte que l'impédance du composant (300) varie avec la fréquence de ladite tension radiofréquence (V) de manière à adapter l'impédance de la source de plasma (100) à l'impédance de ladite au moins une source d'alimentation radiofréquence (200) pour ladite pluralité de différentes fréquences de service (f₀) de ladite tension radiofréquence (V).

14. Procédé selon la revendication 13, **caractérisé en ce qu'**une propriété du plasma est réglée
- par sélection d'une fréquence de service de ladite tension radiofréquence (V) dans ladite pluralité de différentes fréquences de service (f₀), ou
- par sélection de fréquences de service desdites tensions radiofréquences individuelles dans ladite pluralité de différentes fréquences de service (f₀) ainsi que par sélection des amplitudes des tensions radiofréquences individuelles.

15. Procédé selon la revendication 13 ou 14, **caractérisé en ce que** la fraction molaire d'au moins une substance réactive générée dans le plasma est réglée
- par sélection d'une fréquence de service de ladite tension radiofréquence dans ladite pluralité de différentes fréquences de service (f₀), ou
- par sélection de fréquences de service desdites tensions radiofréquences individuelles dans ladite pluralité de différentes fréquences de service (f₀) ainsi que par sélection des amplitudes des tensions radiofréquences individuelles.
